# EUROPEAN PATENT SPECIFICATION

(11) **EP 0 935 288 B1**
(45) Date of publication and mention of the grant of the patent: **02.05.2007**
(21) Application number: 99101613.0
(22) Date of filing: 03.02.1999
(51) Int. Cl.: H01L 23/29, H01L 23/31, H01L 21/56, H05K 3/28

(54) **Sealed structure of semiconductor circuit and method for production thereof**
Versiegelte Anordnung für eine Halbleiterschaltung Verfahren zu deren Herstellung
Structure scellée pour un circuit à semiconducteur et sa méthode de fabrication

(30) Priority: 05.02.1998 JP 2495598
(43) Date of publication of application: 11.08.1999
(73) Proprietor: Lintec Corporation, Tokyo (JP)
(72) Inventor: Ichikawa, Akira, c/o Lintec Corporation, Tokyo (JP); Hasegawa, Naoki, c/o Lintec Corporation, Tokyo (JP); Ebe, Kazuyoshi, c/o Lintec Corporation, Tokyo (JP); Taguchi, Katsuhisa, c/o Lintec Corporation, Tokyo (JP); Yasukazu, Nakata, c/o Lintec Corporation, Tokyo (JP)
(74) Representative: Vossius & Partner

(56) References cited:
- EP-A- 0 626 723
- US-A- 5 520 863
- US-A- 5 612 403
- PATENT ABSTRACTS OF JAPAN vol. 1997, no. 11, 28 November 1997 (1997-11-28) -& JP 09 197965 A (TOSHIBA CHEM CORP), 31 July 1997 (1997-07-31)

## Description

The present invention relates to a method for producing a sealed structure, especially, a smooth, flexible sealed structure, of an electric circuit, and the sealed structure obtained by the method.

Hermetic sealing of a semiconductor chip includes ceramic sealing and resin sealing. Resin sealing is relatively low in reliability, but advantageous in terms of productivity and cost. However, its reliability is becoming unproblematic for practical use, because of improvements such as high performance of a resin material. Electronic parts, such as resin molded IC's, are currently applied to every industrial field, e.g., an electronic tag identification system called data carrier system. As the degree of integration heightens, the chip is becoming upsized. Nonetheless, it is desired that a package be downsized and thinned.

To produce a conventional resin sealing package, a sealing material is processed into a tablet of a predetermined weight and predetermined dimensions. This tablet is preheated until becoming soft, and is then poured into a molding pot that has been prepared. The tablet is heated to a mold temperature until it is completely liquefied, and is pressed into a cavity. With the passage of time under the pressure, a chemical reaction of the resin system produces a cured product, and/or a cooling of the resin system produces a hardened product. The so obtained molded product, i.e., a sealing package, is superposed to a mounted electric circuit to produce a sealed structure.

The use of a sealing package obtained as a solid article by the use of a mold, however, causes level differences or irregularities at the sites of a battery and a chip. Furthermore, a surplus thickness of the resin is needed so that the resin can extend over the entire electric circuit. This makes it difficult to obtain a thin sealed structure.

To solve these problems, Japanese Patent JP-A-09 197 965 describes a method which comprises sandwiching parts of an electronic tag between a plurality of thermoplastic resin plates, setting this assembly in a mold fixed to a hot press, and pressurizing it under predetermined heating conditions to melt the thermoplastic resin plate for integration with the parts of the electronic tag, thereby obtaining a molded product. With this method, however, level differences or irregularities are formed at the surface of the sealed structure. To melt the thermoplastic resin plate, moreover, there is need, generally, to heat it to a temperature above the melting point of the resin, i.e., above 150°C. Thus, the chip or battery in the sealed structure may burst. Also, after the thermoplastic resin plate is processed under heat and pressure, the product needs to be removed from the mold and cooled. During cooling from a high temperature, the thermoplastic resin shrinks markedly, and may break the chip or circuit.

The above-described method, which involves sealing work at a high temperature of 150 °C and higher, poses the problem of destroying the battery, chip or.circuit in the sealed structure, or shortening their lives. A finished product obtained by this method is low in flexibility. Besides, the surface of the sealed structure forms level differences or irregularities, because the battery or chip is present. Thus, it is very difficult to print on the surface of the product, or laminate a decorative label on the surface of the product.

EP-A-0 626 723 describes a resin sheet for encapsulating a semiconductor device. A resin encapsulating sheet having convex portions is prepared, and a semiconductor chip having a surface of an active element is prepared. Then, the convex portion of the sheet is brought into contact with at least the surface of the active element and the sheet is pressed, and the chip is encapsulated.

It is an object of the present invention to provide a method for producing a flexible and smooth-surfaced sealed structure.

The present invention is defined by a method according to claim 1.

The step of curing the curable resin on the substrate may be performed using heat.

Alternatively, the step of curing the curable resin on the substrate may be performed using light.

According to a second aspect of the invention, there is provided a method for producing a sealed structure of an electric circuit, comprising the steps of:
coating a surface of a substrate with a curable resin;
precuring the curable resin on the substrate;
superposing a surface of the precured curable resin on the substrate to a mounted electric circuit; and
curing the precured curable resin.

The step of precuring the curable resin on the substrate may be performed using heat.

Alternatively, the step of precuring the curable resin on the substrate may be performed using light.

The step of curing the precured curable resin may be performed using heat.

Alternatively, the step of curing the precured curable resin may be performed using light.

According to a third aspect of the invention, there is provided a sealed structure of an electric circuit produced by the above-described methods for production.

The above and other objects, effects, features and advantages of the present invention will become more apparent from the following description of the embodiments thereof taken in conjunction with the accompanying drawings.
Fig. 1 is a sectional view showing an embodiment of a sealed structure of an electric circuit produced according to the present invention; and
Fig. 2 is a sectional view showing an embodiment of an electric circuit produced according to the present invention.

The method for production according to the present invention will now be described in detail by reference to the accompanying drawings.

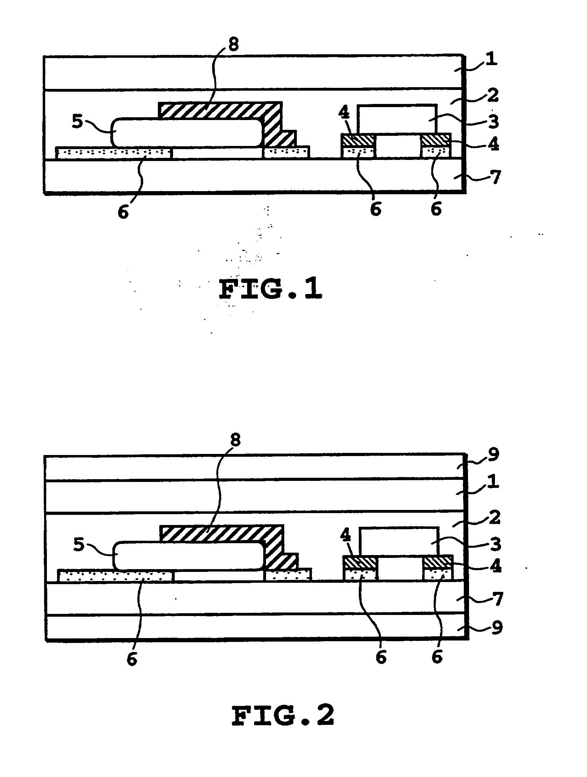

Fig. 1 is a sectional view showing the entire constitution of a sealed structure of an electric circuit according to the present invention. Such a sealed structure of an electric circuit may be produced by any of the following two methods.

A first method is to coat a curable resin 2 onto a substrate 1, and superpose a curable resin surface on the curable resin-coated substrate to a mount surface of a mounted electric circuit which has been prepared.

As shown in Fig. 1, for example, the mounted electric circuit is prepared by placing an IC chip 3 on a circuit board 7 via a conductive adhesive 4 and a conductive ink 6, also placing a button battery 5 on the circuit board 7 via the conductive ink 6, and covering the button battery 5 with a conductive tape 8 to fix it on the circuit board.

After the substrate coated with the curable resin and the mounted electric circuit are superposed together, the curable resin is cured to obtain a desired sealed structure of an electric circuit.

A second method is used when the curable resin has so low viscosity that it is not suitable for a processing by which the curable resin is superposed to the mounted electric circuit to seal it.

According to the second method, the first step is to coat a curable resin 2 onto a substrate 1. The curable resin is irradiated by light and/or heated to precure it so as to be pretreated into a state having a desired viscosity. Then, a precured curable resin surface is superposed to a mount surface of a mounted electric circuit which has been prepared. After the substrate having the precured curable resin and the mounted electric circuit are superposed together, the procured curable resin is cured to obtain a desired sealed structure of an electric circuit.

The sealed structure obtained by the first or second method may further have decorative printing applied to the outer surface of the substrate 1 and/or the circuit board 7, or have a decorative printed label laminated to the outer surface of the substrate 1 and/or the circuit board 7 by use of an adhesive. This printing or laminating is carried out in the conventional manner. Curing in the first or second method may be performed, for example, by heating, oxygen shutoff, moisture addition, or irradiation with light, radiation or electromagnetic wave. Preferred is the use of heat or light.

There is no restriction on the substrate used. Its examples include paper, wood, foils of various metals such as aluminum, iron, copper or stainless steel, and synthetic resins such as polyethylene, polyethylene terephthalate, polyethylene naphthalate, polypropylene, polyvinyl chloride, polyurethane, polyester, polyacrylate, polyacrylic acid, polymethacrylate, polymethacrylic acid, polydimethylsiloxane, polyamide, polycarbonate, polyimide, epoxy resin, phenolic resin, urea resin, melamine resin, diallyl phthalate resin, acrylonitrile styrene resin, and acrylonitrile butadiene styrene resin.

The curable resin used is flexible even when completely cured. More specifically, the curable resin after curing has Young's modulus in flexure in the range of from 0.001 to 50 N/cm², preferably 0.01 to 30 N/cm², more preferably 1 to 20 N/cm².

If the Young's modulus in flexure of the curable resin after curing is lower than this range, the following problem arises: When stress is imposed on the sealed structure of the present invention to change its shape, the sealed structure is not elastically recovered, but remains deformed, even after stress is removed. Thus, its use becomes impossible. When the Young's modulus in flexure is higher than the above range, the sealed structure of the invention, if stressed, cracks for lack of flexibility and can no longer be used.

As the curable resin, there may generally be used mixtures of reactive resins and/or reactive agents with various resins such as polyvinyl acetate, ethylene-vinyl acetate copolymer, ethyl acrylate-methyl methacrylate copolymer, polyethylene terephthalate, polypropylene, polyvinyl chloride, polyurethane, polyester, polyacrylate, polyacrylic acid, polymethacrylate, polymethacrylic acid, polydimethylsiloxane, polyamide, polycarbonate, epoxy resin, phenolic resin, urea resin, melamine resin, diallyl phthalate resin, polyimide, acrylonitrile styrene resin, and acrylonitrile butadiene styrene resin.

Examples of the reactive resins are orthophthalic unsaturated polyester resin, iso-unsaturated polyester resin, bis-phenolic unsaturated polyester resin, polyisoprene, polybutadiene, vinylsiloxane resin, methaphenilene bismaleimide, quinone dioxime, triallyl cyanurate, diallyl phthalate, ethylene glycol dimethacrylate, ethylene glycol diacrylate, diethylene glycol dimethacrylate, diethylene glycol diacrylate, triethylene glycol dimethacrylate, triethylene glycol diacrylate, polyethylene glycol dimethacrylate, polyethylene glycol diacrylate, propylene glycol dimethacrylate, propylene glycol diacrylate, dipropylene glycol dimethacrylate, dipropylene glycol diacrylate, tripropylene glycol dimethacrylate, tripropylene glycol diacrylate, polypropylene glycol dimethacrylate, polypropylene glycol diacrylate, triethylene glycol methacrylate, triethylene glycol acrylate, tridiethylene glycol methacrylate, tridiethylene glycol acrylate, tritriethylene glycol methacrylate, tritriethylene glycol acrylate, tripolyethylene glycol methacrylate, tripolyethylene glycol acrylate, tripropylene glycol methacrylate, tripropylene glycol acrylate, tridipropylene glycol methacrylate, tridipropylene glycol acrylate, tritripropylene glycol methacrylate, tritripropylene glycol acrylate, tripolypropylene glycol methacrylate, tripolypropylene glycol acrylate, triallyl isocyanurate, dimethylolphenol, polymethylolphenol, methylolphenol formaldehyde resin, phenol formaldehyde resin, urea resin, melamine resin, benzoguanamine resin, aminoformaldehyde resin, epichlorohydrin resin, monoethanolamine, diethanolamine, triethanolamine, N-aminoethylpiperazine, ethylenediamine, hexamethylenediamine, bisphenol A type epoxy resin, bisphenol F type epoxy resin, phenolic novolak type epoxy resin, cresolic novolak type epoxy resin, cycloaliphatic epoxy resin, glycidyl ester type epoxy resin, glycidylamine type epoxy resin, and heterocyclic epoxy resin.

Examples of the reactive agents are peroxides such as benzoyl peroxide, t-butyl peroxybenzoate, dicumyl peroxide, and t-butyl peroxide, azo compounds such as diazoaminobenzene, bisazo ester, and azobisisobutyronitrile, isocyanate compounds such as toluidine isocyanate, and hexamethylene diisocyanate, biacetyl, acetophenone, benzophenone, Michler's ketone, benzyl, benzoin, benzoin isobutyl ether, and benzyldimethylketal. Depending on a combination of the reactive resin and the reactive agent, heat or light is used to cause reaction of the curable resin, thereby curing it.

The curable resin before curing can be defined by its properties including viscosity which is determined by a testing method of JIS-K7117. The viscosity of the curable resin before curing is within the range of from 2 to 100 Pa·s according to the testing method of JIS-K7117. Preferably, it is 5 to 50 Pa•s, more preferably 8 to 15 Pa•s. If the viscosity of the curable resin before curing is lower than the above range, the resin is flowable, and poor in shape retention, so that it is difficult to work. If the viscosity is higher than above range, the resin is so hard that when it is superposed.to the mounted electric circuit, excessive stress acts on the electric circuit, destroying it.

When the viscosity of the curable resin before curing is markedly low, it is desirable that heat or light be applied for a short period of time to precure the curable resin, thereby adjusting it to a desired viscosity.

The thickness of the curable resin coated onto the substrate is 1 to 20,000 µm, preferably 10 to 5,000 µm, more preferably 25 to 1,000 µm.

According to the present invention, the curable resin before being superposed to the mounted electric circuit has moderate viscosity, or has been pretreated so as to have moderate viscosity. Since the curable resin is thus suitable for processing, it is superposed to the mounted electric circuit, and can thereby seal the entire mounted electric circuit. Furthermore, the resin has moderate viscosity, so that unlike the resin being used in a liquid state, it enables a sealed structure to be prepared without its sagging or squeeze-out.

Moreover, a sealed structure of an electric circuit that has been obtained in the above manner is free from level differences or marked irregularities on the surface.

As shown in Fig. 2, therefore, a printed label for surface decoration can be laminated onto outer surfaces of the substrate 1 and the circuit board 7 of the sealed structure of the electric circuit obtained in the above-described manner. In Fig. 2, printed labels 9 are laminated onto outer surfaces of both of the substrate and the circuit board. However, the label may be laminated on the outer surface of one of the substrate and the circuit board, depending on uses. Also, instead of laminating the printed label, it is possible to print directly on the outer surfaces of the substrate and the circuit board.

The present invention will now be described in detail by way of Examples, which are given for illustrative purposes, and not limitative of the invention.

### [Examples]

These Examples concretely describe a method for producing a sealed structure of an electric circuit according to the present invention.

### <Example 1>

### Preparation of photocuring resin

To 100 g of a polyurethane resin having a weight average molecular weight of 10,000, 100 g of diethylene glycol dimethacrylate as a reactive resin and 5 g of benzophenone as a reactive agent were added. Further, 500 g of methylene chloride as a solvent was added, and these materials were mixed with stirring to prepare a photocuring resin.

### Method for production of a sealed structure of an electric circuit

The resulting photocuring resin was coated onto a polyethylene terephthalate (PET) film having thickness of 75 µm and measuring 5 × 7 cm as a substrate. The coated film was dried at 50°C for 24 hours. The thickness of the photocuring resin applied was 500 µm. The viscosity of the photocuring resin was 11 Pa•s.

A photocuring resin surface of the so prepared photocuring resin-coated PET film was superposed to a mounted electric circuit.

The mounted electric circuit was prepared in the following manner: On a polyimide film having 100 µm of thickness, a desired circuit was printed by using a conductive printing ink having a silver powder dispersed in an epoxy resin, followed by drying the printed film. An IC chip was fixed thereon via a conductive resin. Further, a button battery was placed via the Ag ink and covered with a conductive tape to fix it on the polyimide film.

After the PET film coated with the photocuring resin and the mounted electric circuit were superposed together, the assembly was irradiated with ultra violet ray for 200 seconds at an illuminance of 120 mW/cm² and a light quantity of 120 J/cm² to cure the photocuring resin completely, thereby obtaining a sealed structure of an electric circuit.

The resulting sealed structure of the electric circuit was flexible, and smooth without irregularities on the surface.

Separately, the photocuring resin was completely cured under the above-mentioned curing conditions without superposing it to the mounted electric circuit. The Young's modulus in flexure of the cured product was measured by means of Perkin-Elmer's dynamic mechanical analyzer DMA-7 attached to a dedicated jig. Its Young's modulus in flexure turned out to be 3 N/cm². The results are shown in Table 1.

### <Example 2>

### Preparation of thermosetting resin

To 100 g of a polyester resin having a weight average molecular weight of 15,000, 100 g of diethylene glycol dimethacrylate as a reactive resin and 10 g of benzoyl peroxide as a reactive agent were added. Further, 500 g of methylene chloride as a solvent was added, and these materials were mixed with stirring to prepare a thermosetting resin.

### Method for production of a sealed structure of an electric circuit

The resulting thermosetting resin was coated onto a polyethylene naphthalate film having thickness of 188 µm and measuring 5 × 7 cm as a substrate. The coated film was dried at 35°C for 48 hours. The thickness of the thermosetting resin applied was 600 µm. The viscosity of the thermosetting resin was 13 Pa·s.

A thermosetting resin surface of the so prepared thermosetting resin-coated polyethylene naphthalate film was superposed to a mounted electric circuit.

The mounted electric circuit was the same as the one used in Example 1.

After the polyethylene naphthalate film coated with the thermosetting resin and the mounted electric circuit were superposed together, the assembly was heat pressed for 30 minutes at 100°C to cure the thermosetting resin completely, thereby obtaining a sealed structure of an electric circuit.

The resulting sealed structure was flexible, and smooth without irregularities on the surface.

Separately, the thermosetting resin was completely cured under the above-mentioned curing conditions without superposing it to the mounted electric circuit. The Young's modulus in flexure of the cured product was measured by means of Perkin-Elmer's dynamic mechanical analyzer DMA-7 attached to a dedicated jig. Its Young's modulus in flexure turned out to be 2.5 N/cm². The results are shown in Table 1.

### <Example 3>

### Preparation of thermosetting resin

To 100 g of an ethyl acrylate-methyl methacrylate copolymer having a weight average molecular weight of 10,000, 70 g of a bisphenol A type epoxy resin and 20 g of hexamethylenediamine as reactive resins were added. Further, 500 g of methylene chloride as a solvent was added, and these materials were mixed with stirring to prepare a thermosetting resin.

### Method for production of a sealed structure of an electric circuit

The resulting thermosetting resin was coated onto a polyethylene naphthalate film having thickness of 188 µm and measuring 5×7 cm as a substrate. The coated film was dried at 35°C for 24 hours. The thickness of the thermosetting resin applied was 500 µm. The viscosity of the thermosetting resin was 9 Pa•s.

A thermosetting resin surface of the so prepared thermosetting resin-coated polyethylene naphthalate film was superposed to a mounted electric circuit.

The mounted electric circuit was the same as the one used in Example 1.

After the polyethylene naphthalate film coated with the thermosetting resin and the mounted electric circuit were superposed together, the assembly was heat pressed for 60 minutes at 100°C to cure the thermosetting resin completely, thereby obtaining a sealed structure of an electric circuit.

The resulting sealed structure was flexible, and smooth without irregularities on the surface.

Separately, the thermosetting resin was completely cured under the above-mentioned curing conditions without superposing it to the mounted electric circuit. The Young's modulus in flexure of the cured product was measured by means of Perkin-Elmer's dynamic mechanical analyzer DMA-7 attached to a dedicated jig. Its Young's modulus in flexure turned out to be 3.1 N/cm². The results are shown in Table 1.

### <Example 4>

### Preparation of photocuring resin

To 100 g of a polyurethane resin having a weight average molecular weight of 5,000, 100 g of diethylene glycol dimethacrylate as a reactive resin and 5 g of benzophenone as a reactive agent were added. These materials were mixed with stirring to prepare a photocuring resin.

### Method for production of a sealed structure of an electric circuit

The resulting photocuring resin was coated onto a polyethylene terephthalate film having thickness of 75 µm and measuring 5×7 cm as a substrate, to a thickness of 600 µm. The viscosity of the photocuring resin was 0.1 Pa•s.

Then, a surface of the photocuring resin was irradiated with ultra violet ray for 20 seconds at an illuminance of 120 mW/cm² and a light quantity of 120 J/cm² to precure the photocuring resin. The viscosity of the precured photocuring resin was 12 Pa·s.

The photocuring resin surface of the so prepared and precured photocuring resin-coated polyethylene terephthalate film was superposed to a mounted electric circuit.

The mounted electric circuit was the same as that used in Example 1.

After the polyethylene terephthalate film coated with the precured photocuring resin and the mounted electric circuit were superposed together, the assembly was irradiated with ultra violet ray for 200 seconds at an illuminance of 120 mW/cm² and a light quantity of 120 J/cm² to cure the photocuring resin completely, thereby obtaining a sealed structure of an electric circuit.

The resulting sealed structure was flexible, and smooth without irregularities on the surface.

Separately, the photocuring resin was precured under the precuring conditions of the present Example, and then completely cured under the curing conditions of the present Example, without superposing it to the mounted electric circuit. The Young's modulus in flexure of the completely cured product was measured by means of Perkin-Elmer's dynamic mechanical analyzer DMA-7 attached to a dedicated jig. Its Young's modulus in flexure turned out to be 2 N/cm². The results are shown in Table 1.

### <Example 5>

### Preparation of thermosetting resin

To 100 g of a polyester resin having a weight average molecular weight of 7,000, 100 g of diethylene glycol dimethacrylate as a reactive resin and 15 g of benzoyl peroxide as a reactive agent were added. These materials were mixed with stirring to prepare a thermosetting resin.

### Method for production of a sealed structure of an electric circuit

The resulting thermosetting resin was coated onto a polyethylene naphthalate film having thickness of 188 µm and measuring 5×7 cm as a substrate to a thickness of 500 µm. The viscosity of the thermosetting resin was 0.2 Pa•s

Then, the thermosetting resin-coated polyethylene naphthalate film was put in a constant temperature bath at 100°C for 3 minutes to precure the thermosetting resin. The viscosity of the precured thermosetting resin was 10 Pa•s.

A thermosetting resin surface of the so prepared and precured thermosetting resin-coated polyethylene naphthalate film was superposed to a mounted electric circuit.

The mounted electric circuit was the same as that used in Example 1.

After the polyethylene naphthalate film coated with the precured thermosetting resin and the mounted electric circuit were superposed together, the assembly was heat pressed for 30 minutes at 100°C to cure the thermosetting resin completely, thereby obtaining a sealed structure of an electric circuit.

The resulting sealed structure was flexible, and smooth without irregularities on the surface.

Separately, the thermosetting resin was precured under the precuring conditions of the present Example, and then completely cured under the curing conditions of the present Example, without superposing it to the mounted electric circuit. The Young's modulus in flexure of the completely cured product was measured by means of Perkin-Elmer's dynamic mechanical analyzer DMA-7 attached to a dedicated jig. Its Young's modulus in flexure turned out to be 2 N/cm². The results are shown in Table 1.

### <Example 6>

### Preparation of thermosetting/photocuring resin

To 80 g of an ethyl acrylate-methyl methacrylate copolymer having a weight average molecular weight of 10,000, 14 g of bisphenol A type epoxy resin and 4 g of hexamethylenediamine as reactive resins were added. Further, 80 g of diethylene glycol dimethacrylate as a reactive resin, and 10 g of benzophenone as a reactive agent were also added. These materials were mixed with stirring to prepare a thermosetting/photocuring resin.

### Method for production of a sealed structure of an electric circuit

The resulting thermosetting/photocuring resin was coated onto a polyethylene naphthalate film having thickness of 75 µm and measuring 5×7 cm as a substrate to a thickness of 600 µm. The viscosity of the thermosetting/photocuring resin was 0.2 Pa•s.

Then, the thermosetting/photocuring resin-coated polyethylene naphthalate film was put in a constant temperature bath at 100°C for 3 minutes to precure the thermosetting/photocuring resin. The viscosity of the precured thermosetting/photocuring resin was 8 Pa•s.

A thermosetting/photocuring resin surface of the so prepared and precured thermosetting/photocuring resin-coated polyethylene naphthalate film was superposed to a mounted electric circuit.

The mounted electric circuit was the same as that used in Example 1.

After the polyethylene naphthalate film coated with the precured thermosetting/photocuring resin and the mounted electric circuit were superposed together, the assembly was irradiated with ultra violet ray for 200 seconds at an illuminance of 120 mW/cm² and a light quantity of 120 J/cm² to cure the thermosetting/photocuring resin completely, thereby obtaining a sealed structure of an electric circuit.

The resulting sealed structure was flexible, and smooth without irregularities on the surface.

Separately, the thermosetting/photocuring resin was precured under the precuring conditions of the present Example, and then completely cured under the curing conditions of the present Example, without superposing it to the mounted electric circuit. The Young's modulus in flexure of the completely cured product was measured by means of Perkin-Elmer's dynamic mechanical analyzer DMA-7 attached to a dedicated jig. Its Young's modulus in flexure turned out to be 2 N/cm². The results are shown in Table 1.

### <Example 7>

### Preparation of photocuring/thermosetting resin

To 80 g of an ethyl acrylate-methyl methacrylate copolymer having a weight average molecular weight of 10,000, 70 g of bisphenol A type epoxy resin and 20 g of hexamethylenediamine as reactive resins were added. Further, 8 g of diethylene glycol dimethacrylate as a reactive resin, and 1 g of benzophenone as a reactive agent were also added. These materials were mixed with stirring to prepare a photocuring/thermosetting resin.

### Method for production of a sealed structure of an electric circuit

The resulting photocuring/thermosetting resin was coated onto a polyethylene naphthalate film having thickness of 75 µm and measuring 5×7 cm as a substrate to a thickness of 600 µm. The viscosity of the photocuring/thermosetting resin was 0.2 Pa•s.

Then, a surface of the photocuring/thermosetting resin was irradiated with ultra violet ray for 20 seconds at an illuminance of 120 mW/cm² and a light quantity of 120 J/cm² to precure the photocuring/thermosetting resin. The viscosity of the precured photocuring/thermosetting resin was 8 Pa•s.

The photocuring/thermosetting resin surface of the so prepared and precured photocuring/thermosetting resin-coated polyethylene naphthalate film was superposed to a mounted electric circuit.

The mounted electric circuit was the same as that used in Example 1.

After the polyethylene naphthalate film coated with the precured photocuring/thermosetting resin and the mounted electric circuit were superposed together, the assembly was heat pressed at 100°C for 30 minutes to cure the photocuring/thermosetting resin completely, thereby obtaining a sealed structure of an electric circuit.

The resulting sealed structure was flexible, and smooth without irregularities on the surface.

Separately, the photocuring/thermosetting resin was precured under the precuring conditions of the present Example, and then completely cured under the curing conditions of the present Example, without superposing it to the mounted electric circuit. The Young's modulus in flexure of the completely cured product was measured by means of Perkin-Elmer's dynamic mechanical analyzer DMA-7 attached to a dedicated jig. Its Young's modulus in flexure turned out to be 3 N/cm². The results are shown in Table 1.

### <Comparative Example 1>

Instead of a curable resin, acrylonitrile butadiene styrene resin as a thermoplastic resin, was used to construct a comparative example. An acrylonitrile butadiene styrene plate having thickness of 500 µm and measuring 5×7 cm, was superposed to a mounted electric circuit.

The mounted electric circuit was the same as that used in Example 1.

After the acrylonitrile butadiene styrene plate and the mounted electric circuit were superposed together, the assembly was heat pressed at 250°C for 30 minutes. During heat pressing, a button battery in a sealed structure of the present comparative example deformed because of excessive heat, and its contents leaked. Furthermore, irregularities occurred at the surface of the sealed structure, and the flexibility of the sealed structure was inferior.

### <Comparative Example 2>

Instead of a curable resin, low density polyethylene resin as a thermoplastic resin, was used to construct a comparative example. A low density polyethylene plate having thickness of 1,000 µm and measuring 5×7 cm, was superposed to a mounted electric circuit.

The mounted electric circuit was the same as that used in Example 1.

After the low density polyethylene plate and the mounted electric circuit were superposed together, the assembly was heat-pressed at 180°C for 30 minutes.

After the heat-pressed product was returned to room temperature, excessive stress acted on the IC chip owing to thermal shrinkage of the low density polyethylene, causing cracking. Furthermore, irregularities occurred at the surface of the sealed structure obtained in this comparative example, and the flexibility of the sealed structure was poor.

**Table 1**

| | Type of resin | Viscosity before precuring (Pa•s) | Precuring method | Viscosity before curing (Pa•s) | Curing method | Young's modulus in flexure (N/cm²) | Flexibility | Irregularities |
|---|---|---|---|---|---|---|---|---|
| Ex. 1 | Curable resin | - | - | 11 | Irradiation with light | 3 | High | Absent |
| Ex. 2 | Curable resin | | | 13 | Heat pressing | 2.5 | High | Absent |
| Ex. 3 | Curable resin | - | - | 9 | Heat pressing | 3.1 | High | Absent |
| Ex. 4 | Curable resin | 0.1 | Irradiation with light | 12 | Irradiation with light | 2 | High | Absent |
| Ex. 5 | Curable resin | 0.2 | Heating | 10 | Heat pressing | 2 | High | Absent |
| Ex. 6 | Curable resin | 0.2 | Heating | 8 | Irradiation with light | 2 | High | Absent |
| Ex. 7 | Curable resin | 0.2 | Irradiation with light | 8 | Heat pressing | 3 | High | Absent |
| Comp. Ex. 1 | Thermoplastic resin | - | - | - | Heat pressing | - | Low | Present |
| Comp. Ex. 2 | Thermoplastic resin | - | - | - | Heat pressing | - | Low | Present |

The above findings show that according to the present invention, a curable resin cured by heat or light is used, and the viscosity of the curable resin is suitable for superposing to an electric circuit with irregularities. Thus, when they are superposed together, the irregularities are accommodated into the curable resin, making the surface smooth. Furthermore, the Young's modulus in flexure of the resin after curing is moderate, so that the sealed structure of the present invention is a flexible assembly. Hence, printing for surface decoration can be performed on the sealed structure, or a printed label for surface decoration can be stuck on the sealed structure. When stress is imposed on the sealed structure to change its shape, moreover, the sealed structure does not crack after removal of stress, because it has moderate flexibility.

## Claims

1. A method for producing a sealed structure of an electric circuit, **characterized by** comprising the steps of:
coating a surface of a substrate (1) with a curable resin (2);
superposing and pressing a surface of the curable resin (2) on the substrate (1) to a mounted electric circuit (7); and
curing the curable resin (2) on the substrate (1), whereas the viscosity of the curable resin (2) is 8 to 15 Pa•s.

2. The method of claim 1, **characterized in that** the step of curing the curable resin (2) on the substrate (1) is performed using heat.

3. The method of claim 1 or 2, **characterized in that** the step of curing the curable resin (2) on the substrate (1) is performed using light.

4. The method of any of claims 1 to 3, further comprising the step of: precuring the curable resin (2) on the substrate (1); after said step of
coating the surface of a substrate (1) with a curable resin (2).

5. The method of claim 4, **characterized in that** the step of precuring the curable resin (2) on the substrate (1) is performed using heat.

6. The method of claim 4 or 5, **characterized in that** the step of precuring the curable resin (2) on the substrate (1) is performed using light.

## Patentansprüche

1. Verfahren zur Herstellung einer versiegelten Anordnung einer elektrischen Schaltung, **gekennzeichnet durch** die Schritte:
Beschichten einer Oberfläche eines Substrats (1) mit einem härtbaren Harz (2);
Aufbringen und Aufdrücken einer Fläche des härtbaren Harzes (2) auf dem Substrat (1) auf eine montierte elektrische Schaltung (7); und
Härten des härtbaren Harzes (2) auf dem Substrat (1), wobei die Viskosität des härtbaren Harzes (2) von 8 bis 15 Pa·s beträgt.

2. Verfahren nach Anspruch 1, **dadurch gekennzeichnet, daß** der Schritt des Härtens des härtbaren Harzes (2) auf dem Substrat (1) unter Verwendung von Wärme durchgeführt wird.

3. Verfahren nach Anspruch 1 oder 2, **dadurch gekennzeichnet, daß** der Schritt des Härtens des härtbaren Harzes (2) auf dem Substrat (1) unter Verwendung von Licht durchgeführt wird.

4. Verfahren nach einem der Ansprüche 1 bis 3, ferner mit dem Schritt:
Vorhärten des härtbaren Harzes (2) auf dem Substrat (1) nach dem Schritt des Beschichtens der Oberfläche eines Substrats (1) mit einem härtbaren Harz (2).

5. Verfahren nach Anspruch 4, **dadurch gekennzeichnet, daß** der Schritt des Vorhärtens des härtbaren Harzes (2) auf dem Substrat (1) unter Verwendung von Wärme durchgeführt wird.

6. Verfahren nach Anspruch 4 oder 5, **dadurch gekennzeichnet, daß** der Schritt des Vorhärtens des härtbaren Harzes (2) auf dem Substrat (1) unter Verwendung von Licht durchgeführt wird.

## Revendications

1. Un procédé pour produire une structure scellée d'un circuit électrique,
**caractérisé par** le fait de comprendre les étapes consistant à:
- revêtir une surface d'un substrat (1) avec une résine (2) polymérisable;
- superposer et presser une surface de la résine (2) polymérisable sur le substrat (1) sur un circuit électrique (7) monté; et polymériser la résine (2) polymérisable sur le substrat (1), tandis que la viscosité de la résine (2) polymérisable est dans la fourchette de 8 à 15 Pa·s.

2. Le procédé selon la revendication 1, **caractérisé en ce que** l'étape de polymérisation de la résine (2) polymérisable sur le substrat (1) est effectuée en utilisant de la chaleur.

3. Le procédé selon la revendication 1 ou 2, **caractérisé en ce que** l'étape de polymérisation de la résine (2) polymérisable sur le substrat (1) est effectuée en utilisant de la lumière.

4. Le procédé selon l'une quelconque des revendications 1 à 3, comprenant en outre l'étape consistant à:
- prépolymériser la résine (2) polymérisable sur le substrat (1) après ladite étape consistant à revêtir la surface d'un substrat (1) avec une résine (2) polymérisable.

5. Le procédé selon la revendication 4, **caractérisé en ce que** l'étape de prépolymérisation de la résine (2) polymérisable sur le substrat (1) est effectuée en utilisant de la chaleur.

6. Le procédé selon la revendication 4 ou 5, **caractérisé en ce que** l'étape de prépolymérisation de la résine (2) polymérisable sur le substrat (1) est effectuée en utilisant de la lumière.
